# EUROPEAN PATENT APPLICATION

(11) **EP 4 498 601 A1**
(43) Date of publication of application: **29.01.2025**
(21) Application number: 24184228.5
(22) Date of filing: 25.06.2024
(51) Int. Cl.: H03F 1/18, H03F 1/56, H03F 3/195, H03F 3/21, H03F 3/24, H03F 3/45

(54) **MULTI-STACK POWER AMPLIFIER**

(30) Priority: 28.07.2023 KR 20230099131
(71) Applicant: Samsung Electronics Co., Ltd., Suwon-si, Gyeonggi-do 16677 (KR)
(72) Inventor: YUN, Jongwon, 16677 Suwon-si (KR); JEONG, Jaeyeon, 16677 Suwon-si (KR); PARK, Hyunchul, 16677 Suwon-si (KR); YOO, Sangmin, 16677 Suwon-si (KR); HUR, Joonhoi, 16677 Suwon-si (KR)
(74) Representative: Marks & Clerk LLP

(57) **Abstract**

A multi-stack power amplifier (100) having a differential structure includes a first stack (110) including a first amplifier element (111), configured to amplify a first signal having a first phase, and a second amplifier element (112) configured to amplify a second signal having a second phase opposite to the first phase; and a second stack (120) including a third amplifier element (113), connected to an output terminal of the first amplifier element (111) through a first interconnection (10), and a fourth amplifier element (114) connected to an output terminal of the second amplifier element (112) through a second interconnection (20) intersecting the first interconnection.

## Description

### BACKGROUND

Example embodiments relate to a power amplifier, and more particularly, to a multi-stack power amplifier.

In a wireless communication system, a power amplifier serves to amplify power of a transmitter signal such that electromagnetic waves may reach a desired destination through an antenna.

Since a power amplifier consumes about 70% or more of total power consumption of a transmitter, high efficiency is required. To this end, the power amplifier should satisfy various specifications such as linearity that is an indicator of signal distortion, saturated output power P_{SAT} that is an indicator of signal strength, or power added efficiency (PAE) that is an indicator of circuit power efficiency. However, there may be stability or circuit size issues with the power amplifier when trying to satisfy the various specifications.

### SUMMARY

Example embodiments provide a multi-stack power amplifier having a differential structure, which may reduce circuit instability caused by feedback of an unwanted signal and improve stack efficiency without an additional layout space.

According to an example embodiment, a multi-stack power amplifier having a differential structure includes a first stack including a first amplifier element, configured to amplify a first signal having a first phase, and a second amplifier element configured to amplify a second signal having a second phase opposite to the first phase; and a second stack including a third amplifier element, connected to an output terminal of the first amplifier element through a first interconnection, and a fourth amplifier element connected to an output terminal of the second amplifier element through a second interconnection intersecting the first interconnection.

A phase of a first coupling signal, coupled to a first ground through the first amplifier element, and a phase of a second coupling signal, coupled to the first ground through the fourth amplifier element, may be opposite to each other. In addition, a phase of a third coupling signal, coupled to a second ground through the second amplifier element, and a phase of a fourth coupling signal, coupled to the second ground through the third amplifier element, may be opposite to each other.

The first ground may include a ground of the first amplifier element and a ground of the fourth amplifier element, connected to each other, and the second ground may include a ground of the second amplifier element and a ground of the third amplifier element, connected to each other.

A first virtual ground, in which the first coupling signal and the second coupling signal cancel each other out, may be formed in a region through which a ground of the first amplifier element and the ground of the fourth amplifier element are connected to each other. A second virtual ground, in which the third coupling signal and the fourth coupling signal cancel each other out, may be formed in a region through which a ground of the second amplifier element and a ground of the third amplifier element are connected to each other.

Each of the first and second interconnections may be disposed within a layout space comprising the first to fourth amplifier elements.

The first interconnection may include an inductance configured to compensate for a phase difference between an output signal of the first amplifier element and an output signal of the third amplifier element, and the second interconnection may include an inductance configured to compensate for a phase difference between an output signal of the second amplifier element and an output signal of the fourth amplifier.

The inductance of the first interconnection may have a value causing the output signal of the first amplifier element and the output signal of the third amplifier element to be in phase, and the inductance of the second interconnection may have a value causing the output signal of the second amplifier element and the output signal of the fourth amplifier element to be in phase.

The first to fourth amplifier elements may be disposed on a substrate including a plurality of layers, and the first interconnection and the second interconnection may intersect each other through different layers of the plurality of layers.

The multi-stack power amplifier may include a third stack including a fifth amplifier element, configured to amplify a first input signal of a differential input signal and generate the first signal, and a sixth amplifier element configured to amplify a second input signal of the differential input signal and generate the second signal. Each of the fifth and sixth amplifier elements may be a common source amplifier, and each of the first to fourth amplifier elements may be a common gate amplifier.

The multi-stack power amplifier may include a first feedback capacitor connected between a ground of the first amplifier element and a gate terminal of the first amplifier element, a second feedback capacitor connected between a ground of the second amplifier element and a gate terminal of the second amplifier element, a third feedback capacitor connected between a ground of the third amplifier element and a gate terminal of the third amplifier element, and a fourth feedback capacitor connected between a ground of the fourth amplifier element and a gate terminal of the fourth amplifier element.

The first coupling signal may include an output signal of the first amplifier element, coupled to the ground of the first amplifier element through a parasitic capacitance component of the first amplifier element and the first feedback capacitor, the second coupling signal may include an output signal of the fourth amplifier element, coupled to the ground of the fourth amplifier element through a parasitic capacitance component of the fourth amplifier element and the fourth feedback capacitor, the third coupling signal may include an output signal of the second amplifier element, coupled to the ground of the second amplifier element through a parasitic capacitance component of the second amplifier element and the second feedback capacitor, and the fourth coupling signal may include an output signal of the third amplifier element, coupled to the ground of the third amplifier element through a parasitic capacitance component of the third amplifier element and the third feedback capacitor.

The first input signal may be input to a gate terminal of the fifth amplifier element, the second input signal may be input to a gate terminal of the sixth amplifier element, the first signal, output from a drain terminal of the fifth amplifier element, may be input to a source terminal of the first amplifier element, and the second signal, output from a drain terminal of the sixth amplifier element, may be input to a source terminal of the second amplifier element.

The multi-stack power amplifier may include a first neutralization capacitor having one end, connected to a gate terminal of the fifth amplifier element, and the other end commonly connected to a drain terminal of the sixth amplifier element and a source terminal of the second amplifier element; and a second neutralization capacitor having one end, connected to a gate terminal of the sixth amplifier element, and the other end commonly connected to a drain terminal of the fifth amplifier element and a source terminal of the fifth amplifier element.

The multi-stack power amplifier may include an input matching unit, configured to perform impedance matching with an external circuit providing the differential input signal, and an output matching unit configured to adjust impedance viewed at a side of a load from output terminals of the third and fourth amplifier elements.

The first signal may be a first input signal of a differential input signal, the second signal may be a second input signal of the differential input signal, each of the first and second amplifier elements may be a common source amplifier, and each of the third and fourth amplifier elements may be a common gate amplifier.

A source terminal of the first amplifier element and a source terminal of the second amplifier element may be connected to a ground of the first amplifier element and a ground of the second amplifier element, respectively. The multi-stack power amplifier may include a first feedback capacitor, connected between a ground of the third amplifier element and a gate terminal of the third amplifier element, and a second feedback capacitor connected between a ground of the fourth amplifier element and a gate terminal of the fourth amplifier element.

The first coupling signal may include an output signal of the first amplifier element, coupled to the ground of the first amplifier element through a parasitic capacitance component of the first amplifier element. The second coupling signal may include an output signal of the fourth amplifier element, coupled to the ground of the fourth amplifier element through a parasitic capacitance component of the fourth amplifier element and the second feedback capacitor. The third coupling signal may include an output signal of the second amplifier element, coupled to the ground of the second amplifier element through a parasitic capacitance component of the second amplifier element. The fourth coupling signal may include an output signal of the third amplifier element, coupled to the ground of the third amplifier element through a parasitic capacitance component of the third amplifier element and the first feedback capacitor.

The multi-stack power amplifier may include an input matching unit, configured to perform impedance matching with an external circuit providing the differential input signal, and an output matching unit configured to adjust impedance viewed at a side of a load from output terminals of the third and fourth amplifier elements.

According to an example embodiment, a multi-stack power amplifier having a differential structure includes a first stack including a first amplifier element, configured to amplify a first signal having a first phase, and a second amplifier element configured to amplify a second signal having a phase opposite to the first phase; and a second stack including a third amplifier element, configured to amplify an output signal of the first amplifier element, and a fourth amplifier element configured to amplify an output signal of the second amplifier element. The first amplifier element and the second amplifier element may be cross-coupled to the third amplifier element and the fourth amplifier element to form a virtual ground between the first stack and the second stack.

According to an example embodiment, a multi-stack power amplifier having a differential structure includes a first amplifier stage including a first amplifier element, configured to amplify a first signal having a first phase, and a second amplifier element configured to amplify a second signal having a phase opposite to the first phase; and a second amplifier stage including a third amplifier element, connected to an output terminal of the first amplifier element through a first interconnection, and a fourth amplifier element connected to an output terminal of the second amplifier element through a second interconnection intersecting the first interconnection. Inductance of the first interconnection may have a value causing an output signal of the first amplifier element and an output signal of the third amplifier element to be in phase, and inductance of the second interconnection may have a value causing an output signal of the second amplifier element and an output signal of the fourth amplifier element to be in phase.

At least some of the above and other features of the invention are set out in the claims.

### BRIEF DESCRIPTION OF DRAWINGS

The above and other aspects, features, and advantages of the present disclosure will be more clearly understood from the following detailed description, taken in conjunction with the accompanying drawings.
FIG. 1 is a block diagram of a multi-stack power amplifier according to an example embodiment.
FIG. 2A is a block diagram illustrating a configuration of a general multi-stack power amplifier.
FIG. 2B is a graph illustrating a ground voltage of the power amplifier of FIG. 2A.
FIG. 2C is a diagram illustrating a decrease in stack efficiency of the power amplifier of FIG. 2A.
FIG. 2D is a diagram illustrating a general technique for improving stack efficiency.
FIG. 2E is a diagram illustrating a general technique for improving stack efficiency.
FIG. 2F is a diagram illustrating a general technique for improving stack efficiency.
FIG. 3A is a diagram illustrating an operation of a multi-stack power amplifier according to an example embodiment.
FIG. 3B is a diagram illustrating an operation of a multi-stack power amplifier according to an example embodiment.
FIG. 4 is a block diagram of a 3-stack power amplifier according to an example embodiment.
FIG. 5 is a circuit diagram illustrating an example of how to implement the 3-stack power amplifier of FIG. 4.
FIG. 6 is a diagram illustrating an example of a layout of the 3-stack power amplifier of FIG. 5.
FIG. 7 is a block diagram of a 2-stack amplifier according to an example embodiment.
FIG. 8 is a circuit diagram illustrating an example of how to implement the 2-stack amplifier of FIG. 7.
FIG. 9 is a diagram illustrating an example of a layout of the 2-stack power amplifier of FIG. 8.
FIG. 10 is a block diagram of a 4-stack power amplifier according to an example embodiment.

### DETAILED DESCRIPTION

Hereinafter, example embodiments will be described with reference to the accompanying drawings.

The expression "a first," "a second," "the first," or "the second" used in various embodiments of the present disclosure modifies various components regardless of the order or the importance but does not limit the corresponding components.

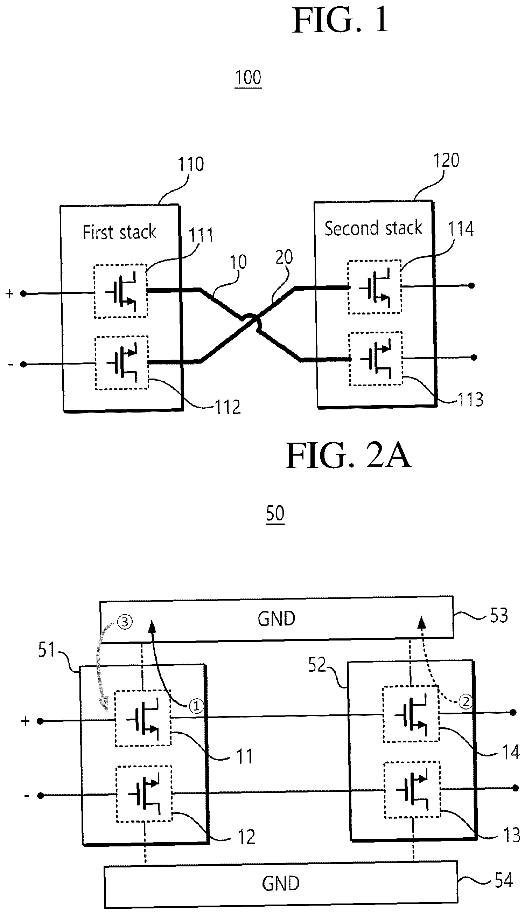

FIG. 1 is a block diagram illustrating a configuration of a multi-stack power amplifier according to an example embodiment. Referring to FIG. 1, a multi-stack power amplifier 100 has a differential structure, and include a first stack 110 and a second stack 120.

The first stack 110 includes a first amplifier element 111, amplifying a first signal of a first phase, and a second amplifier element 112 amplifying a second signal of a second phase opposite to the first phase. According to an example embodiment, the first amplifier element 111 may receive the first signal through a positive terminal, and may amplify the received first signal. The second amplifier element 112 may receive a second signal through a negative terminal, and may amplify the received second signal. In this case, the first signal and the second signal have phases opposite to each other.

The second stack 120 include a third amplifier element 113, amplifying an output signal of the first amplifier element 111, and a fourth amplifier element 114 amplifying an output signal of the second amplifier element 112. According to an embodiment, the third amplifier element 113 is connected to an output terminal of the first amplifier element 111 through a first interconnection 10, and the fourth amplifier element 114 is connected to an output terminal of the second amplifier element 112 through a second interconnection 20 intersecting the interconnection 10. In this case, a phase of the output signal of the fourth amplifier element 114 may be opposite to a phase of the output signal of the first amplifier element 111, and a phase of the output signal of the third amplifier element 113 may be opposite to a phase of the output signal of the amplifier element 112.

Each of the first to fourth amplifier elements 111, 112, 113, and 114 may be implemented as, for example, a field effect transistor (FET), and may have a parasitic capacitance component. Accordingly, the output signal of each of the amplifier elements 111, 112, 113, and 114 may be coupled to a ground of a corresponding amplifier element through the corresponding amplifier element.

Therefore, according to an example embodiment, a phase of a first coupling signal coupled to a first ground through the first amplifier element 111 and a phase of a second coupling signal coupled to the first ground through the fourth amplifier element 114 may be opposite to each other. In addition, a phase of a third coupling signal coupled to a second ground through the second amplifier element 112 and a phase of a fourth coupling signal coupled to the second ground through the third amplifier element 113 may be opposite to each other.

According to an example embodiment, the first ground may include a ground of the first amplifier element 111 and a ground of the fourth amplifier element 114, which are connected to each other. The second ground may include a ground of the second amplifier element 112 and a ground of the third amplifier element 113, which are connected to each other.

Accordingly, a first virtual ground may be formed in a region of the first ground in which the ground of the amplifier element 111 and the ground of the fourth amplifier element 114 are connected to each other, and a second virtual ground may be formed in a region of the second ground in which the ground of the second amplifier element 112 and the ground of the third amplifier element 113 are connected to each other. The first coupling signal and the second coupling signal cancel each other out in the first virtual ground, and the third coupling signal and the fourth coupling signal cancel each other out in the second virtual ground.

As described above, according to an example embodiment, a virtual ground may be formed between stacks by cross-coupling amplifier elements between the stacks. Feedback of an unwanted signal may be prevented by the virtual ground, resulting in improved stability of the power amplifier 100. This will be described in detail later.

In the case of a multi-stack power amplifier, phase misalignment of an output signal may occur between stacks due to a parasitic capacitance component of an amplifier element. For example, the third amplifier element 113 may amplify an output signal of the first amplifier element 111, so that it is ideal for the output signals of the first amplifier device 111 and the third amplifier device 113 to have the same phase. However, if a parasitic capacitance component is present in the third amplifier element 113, phase misalignment may occur between the output signal of the first amplifier element 111 (for example, an input signal of the third amplifier element 113) and the output signal of the third amplifier element 113. Similarly, phase misalignment may occur between the output signal of the second amplifier element 112 (for example, an output signal of the fourth amplifier element 114) and the output signal of the fourth amplifier element 114.

A phase misalignment of output signals causes a decrease in stack efficiency of the multi-stack power amplifier 100, so that there is a need to compensate for the phase misalignment. For example, the above-mentioned phase misalignment of output signals is caused by a parasitic capacitance component of an amplifier element, so that an inductance component corresponding to the parasitic component of the amplifier element may be appropriately added to compensate for the phase misalignment.

According to an example embodiment, a series inductor may be implemented using a layout space between the stacks 110 and 120 of the multi-stack power amplifier 100. In the layout space between the stacks 110 and 120, a first interconnection 10 and a second interconnection 20 may be provided to cross-couple the amplifier elements 111, 112, 113, and 114 and may each have an inductance component. Therefore, according to an example embodiment, series inductors may be implemented in the layout space between the stacks 110 and 120 using the first and second interconnections 10 and 20. In this case, the first interconnection 10 may be a first series inductor, and the second interconnection 20 may become a second series inductor.

According to an example embodiment, inductance of the first interconnection 10 may have a value causing the output signal of the first amplifier element 111 and the output signal of the third amplifier element 113 to be in phase. For example, the inductance of the first interconnection 10 may have a value corresponding to the parasitic capacitance component of the third amplifier element 113, but example embodiments are not limited thereto. Accordingly, phase misalignment between the output signal of the first amplifier element 111 and the output signal of the third amplifier element 113 may be compensated for.

Inductance of the second interconnection 20 may have a value causing the output signal of the second amplifier element 112 and the output signal of the fourth amplifier element 114 to be in phase. For example, the inductance of the second interconnection 20 may have a value corresponding to a parasitic capacitance component of the fourth amplifier element 114, but example embodiments are not limited thereto. Accordingly, phase misalignment between the output signal of the second amplifier element 112 and the output signal of the fourth amplifier element 114 may be compensated for.

In this case, inductance values of the first interconnection 10 and the second interconnection 20 may be implemented in the layout space between the first stack 110 and the second stack 120 by adjusting a path, a length, a width, and the material type of each of the interconnections 10 and 20.

As described above, according to an example embodiment, a series inductor may be implemented using the layout space between the stacks 110 and 120 of the multi-stack power amplifier 100. Therefore, stack efficiency of the multi-stack power amplifier may be improved without an additional layout space.

FIG. 2A is a block diagram illustrating a configuration of a general multi-stack power amplifier. Referring to FIG. 2A, a general multi-stack power amplifier 50 includes a first stack 51 and a second stack 52. The first stack 51 includes a first amplifier element 11 and a second amplifier element 12, and the second stack 52 includes a third amplifier element 13 and a fourth amplifier element 14.

In the general multi-stack power amplifier 50, the amplifier elements 11, 12, 13, and 14 are not cross-coupled between the stacks 51 and 52. For example, a first coupling signal ① coupled to a first ground 53 through the first amplifier element 11 and a second coupling signal ② coupled to a first ground 53 through the fourth amplifier element 14 may be in phase. Accordingly, the first coupling signal ① and the second coupling signal ② may be added together, rather than cancel each other out, in a first ground 53 to generate a greater signal ③.

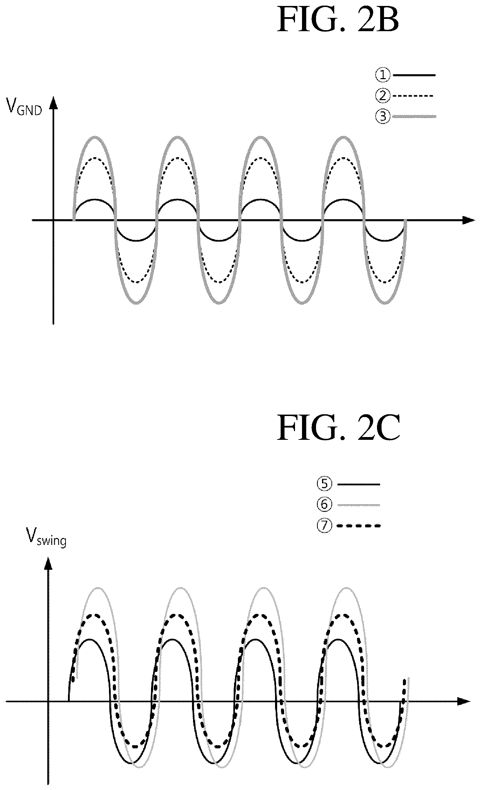

FIG. 2B is a graph illustrating a voltage of the first ground 53 of the power amplifier 50 of FIG. 2A. Referring to FIG. 2B, it can be seen that the first coupling signal CD and the second coupling signal ② of the same phase are added together to generate the greater signal ③ in the first ground 53.

In a high-frequency band such as mmWave, a ground of the power amplifier exhibits inductive characteristics, so that a ground signal may be fed back to an amplifier element of the power amplifier. For example, the greater signal ③ generated in the first ground 53 of FIG. 2A may be fed back to an input terminal of the first amplifier element 11. In this case, performance of the power amplifier 50 may deteriorate due to feedback of an unwanted greater signal. In addition, when a feedback loop is formed, the power amplifier 50 may oscillate.

FIG. 2C is a diagram illustrating a decrease in stack efficiency of the general multi-stack power amplifier 50 of FIG. 2A. FIG. 2C illustrates a voltage swing (5) of an input signal, a voltage swing (6) of an output signal, and a voltage swing difference ⑦ between the two signals of the fourth amplifier element 14 of the power amplifier 50 of FIG. 2A. Referring to FIG. 2C, it can be seen that a parasitic capacitance component of the fourth amplifier element 14 causes phase misalignment between the input signal (5) and the output signal (6), resulting in a large voltage swing difference ⑦. For this reason, the stack efficiency of the power amplifier 50 may deteriorate.

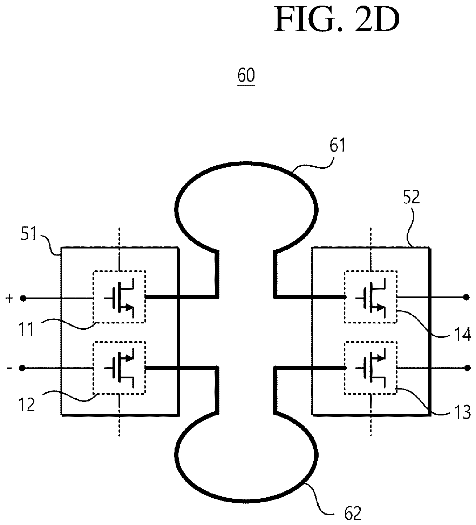

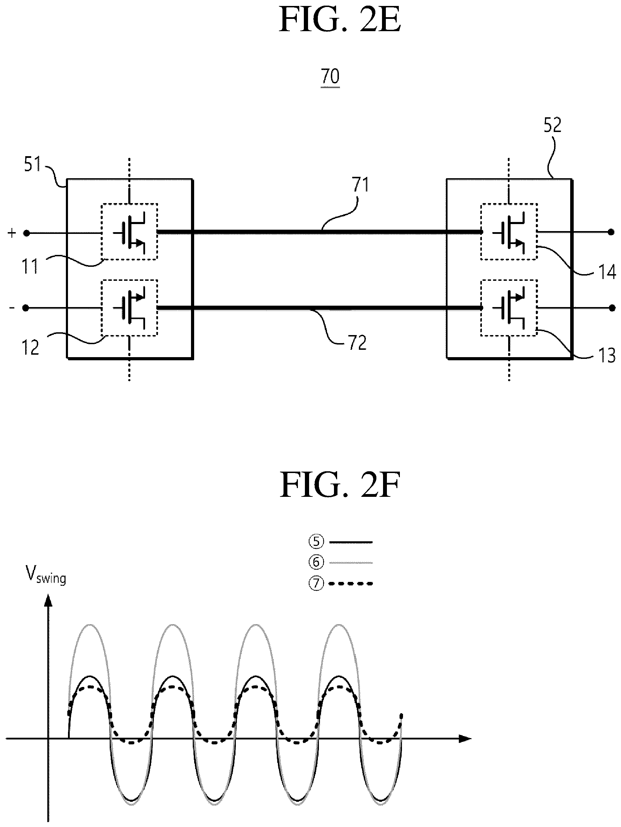

FIGS. 2D, 2E, and 2F are diagrams illustrating general techniques for improving stack efficiency of a multi-stack power amplifier. FIGS. 2D and 2E illustrate examples of how to implement general multi-stack power amplifiers 60 and 70, and FIG. 2F illustrates a voltage swing of an input signal (5), a voltage swing of an output signal ⑥, and a voltage swing difference ⑦ between the two signals of a fourth amplifier element 14 of each of the power amplifier 60 and 70 of FIGS. 2D and 2E.

As described above, phase misalignment between output signals is caused by a parasitic capacitance component of an amplifier element, so that an inductance component corresponding to the parasitic capacitance component of the amplifier element may be appropriately added to compensate for the phase misalignment.

Referring to FIG. 2D, the multi-stack power amplifier 60 may include a series inductor 61 between a first amplifier element 11 and a fourth amplifier element 14 and a series inductor 62 between a second amplifier element 12 and a third amplifier element 13. As illustrated in the drawing, an additional layout space is required in a vertical direction to achieve a desired inductance value while maintaining a distance between a first stack 51 and a second stack 52 as illustrated in FIG. 2A.

Referring to FIG. 2E, the multi-stack power amplifier 70 may include a series inductor 71 between a first amplifier element 11 and a fourth amplifier element 14 and a series inductor 72 between a second amplifier 12 and a third amplifier element 13. As illustrated in the drawing, a distance between the first stack 51 and the second stack 52 may be increased compared with that of FIG. 2A to achieve a desired inductance value.

The above-implemented series inductors 61, 62, 71, and 72 may remove a parasitic capacitance component of the fourth amplifier element 14 and a parasitic capacitance component of the third amplifier element 13, respectively. Accordingly, phase misalignment between the output signals of the stack 51 and the output signals of the stack 52 may be compensated for. For example, referring to FIG. 2F, it can be seen that phases of the input signal (5) and the output signal (6) of the fourth amplifier element 14 are aligned to reduce a voltage swing difference ⑦ compared with that of FIG. 2C. Accordingly, the stack efficiency of the power amplifier 60 may be improved.

However, any of the above-described general techniques of Figure 2 for improving stack efficiency has the disadvantage that a layout area of the power amplifier 60 increases by the added series inductors 61, 62, 71, and 72.

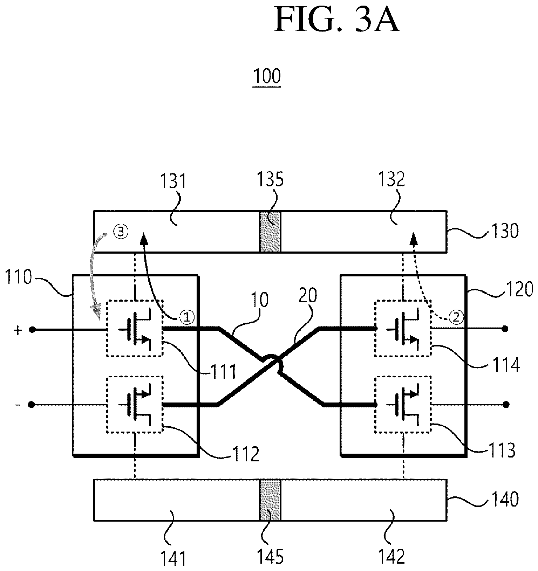

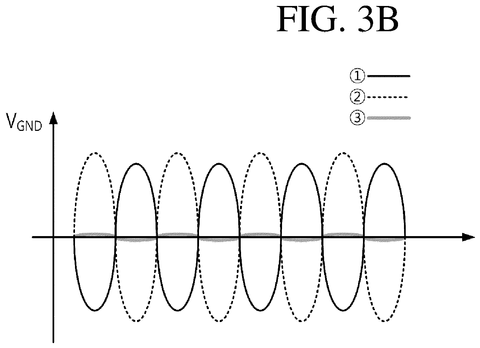

FIGS. 3A and 3B are diagrams illustrating an operation of a multi-stack power amplifier according to an example embodiment. FIG. 3A is a block diagram illustrating an example of how to implement the multi-stack power amplifier 100 of FIG. 1, and FIG. 3B is a graph illustrating a voltage at a first ground 130 of the power amplifier 100 of FIG. 3A. In description of FIG. 3A, redundant descriptions overlapping those provided above with reference to FIG. 1 will be omitted.

Referring to FIG. 3A, the multi-stack power amplifier 100 may include a first ground 130, in which a ground 131 of a first amplifier element 111 and a ground 132 of a fourth amplifier element 114 are connected to each other, and a second ground 140 in which a ground 141 of a second amplifier element 112 and a ground 142 of a third amplifier element 113 are connected to each other.

The amplifier elements 111, 112, 113, and 114 of the multi-stack power amplifier 100 are cross-coupled to each other between stacks 110 and 120 through a first interconnection 10 and a second interconnection 20. In this case, a phase of an output signal of the first amplifier element 111 may be opposite to a phase of an output signal of the fourth amplifier element 114, and a phase of an output signal of the third amplifier element 113 may be opposite to a phase of an output signal of the second amplifier element 112.

The output signal of each of the amplifier elements 111, 112, 113, and 114 may be coupled to a ground of a corresponding amplifier element through a parasitic capacitance component present between terminals (for example, a gate terminal, a source terminal, and a drain terminal) of the corresponding amplifier element.

Therefore, according to an example embodiment, a phase of a first coupling signal ① coupled to the ground 131 of the first amplifier element 111 through the first amplifier element 111 and a phases of a second coupling signal ② coupled to the ground 132 of the fourth amplifier element 114 through the fourth amplifier element 114 may be opposite to each other. In this case, the first coupling signal ① and the second coupling signal ② may cancel each other out in the first ground 130, and a first virtual ground may be formed in a region 135 through which the grounds 131 and 132 are connected to each other.

In addition, a phase of a third coupling signal coupled to the ground 141 of the second amplifier element 112 through the second amplifier element 112 and a phase of a fourth coupling signal coupled to the ground 142 of the third amplifier element 113 through the third amplifier element 113 may be opposite to each other. In this case, the third coupling signal and the fourth coupling signal may cancel each other out in the second ground 140, and a second virtual ground may be formed in a region 145 through which the grounds 141 and 142 are connected to each other.

When the first and second virtual grounds are formed, the first ground 130 and the second ground 140 may have more enhanced ground characteristics. Accordingly, stability of the multi-stack power amplifier 100 may be improved. For example, referring to FIG. 3B, the first coupling signal CD and the second coupling signal ② coupled to the first ground 130 have opposite phases. Therefore, the first coupling signal CD and the second coupling signal ② may cancel out each other, and only a greater signal ③ may be generated in the first ground 130. Accordingly, there may be almost no signal fed back from the first ground 130 to an input terminal of the first amplifier 111, and the stability of the multi-stack power amplifier 100 may be improved.

Referring to FIG. 3A, the first interconnection 10 and the second interconnection 20 cross-couple the first stack 110 and the second stack 120. Accordingly, series inductors may be implemented using a layout space between the first stack 110 and the second stack 120, in which the first interconnection 10 and the second interconnection 20 intersect each other. As compared to the structure illustrated in FIG. 2A in which the stacks 51 and 52 are not cross-coupled, a length of an interconnection is increased within the same area, so that series inductance may be added in proportion to the increased length of the interconnection.

According to an example embodiment, the inductance of the first interconnection 10 may have a value causing the output signal of the first amplifier element 111 and the output signal of the third amplifier element 113 to be in phase, and the inductance of the second interconnection 20 may have a value causing the output signal of the second amplifier element 112 and the output signal of the fourth amplifier element 114 to be in phase.

Accordingly, phase misalignment between the output signal of the first amplifier element 111 and the output signal of the third amplifier element 113 and phase misalignment between the output signal of the second amplifier element 112 and the output signal of the fourth amplifier element 114 may be compensated for.

As described above, series inductors for compensating for a phase misalignment between output signals may be implemented using the interconnections 10 and 20 cross-coupled in a layout space between the stacks 110 and 120. Accordingly, the stack efficiency of the multi-stack power amplifier 100 may be improved without increasing a layout space required to add an inductor, as in the general techniques described above with reference to FIGS. 2D to 2E.

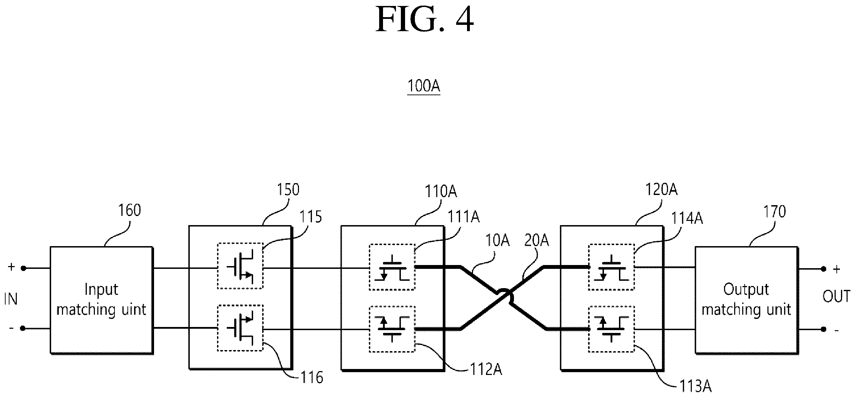

FIG. 4 is a block diagram of a 3-stack power amplifier according to an example embodiment. Referring to FIG. 4, a 3-stack power amplifier 100A may include a first stack 110A, a second stack 120A, a third stack 150, an input matching unit 160, and an output matching unit 170. The 3-stack power amplifier 100A may have a differential structure in which a differential input signal IN is amplified to output a differential output signal OUT.

The input matching unit 160 may receive and transmit the differential input signal IN to the third stack 150. In this case, the input matching unit 160 may perform impedance matching with an external circuit providing the differential input signal IN.

The third stack 150 may include a fifth amplifier element 115 and a sixth amplifier element 116. The fifth amplifier element 115 may amplifier a first input signal (for example, a signal input to a positive terminal) of the differential input signal IN, and may then output the amplified first input signal to the first amplifier element 111A of the first stack 110A. The sixth amplifier element 116 may amplify a second input signal (for example, a signal input to a negative terminal) of the differential input signal IN, and may then the amplified second input signal to the second amplifier element 112A of the first stack 110A. In this case, the first input signal and the second input signal may have opposite phases.

The first stack 110A may include a first amplifier element 111A and a second amplifier element 112A. The first amplifier element 111A may amplify an output signal of the fifth amplifier element 115, and may then output the amplified output signal to the third amplifier element 113A of the second stack 120A. The second amplifier element 112A may amplify an output signal of the sixth amplifier element 116, and may then output the amplified output signal to the fourth amplifier element 114A of the second stack 120A.

The second stack 120A may include a third amplifier element 113A and a fourth amplifier element 114A. The third amplifier element 113A may be connected to an output terminal of the first amplifier element 111A through a first interconnection 10A to amplify the output signal of the first amplifier element 111A. The fourth amplifier element 114A may be connected to the output terminal of the second amplifier element 112A through the second interconnection 20A, intersecting the first interconnection 10A, to amplify the output signal of the second amplifier element 112A.

The benefits of circuit stability improved by forming a virtual ground between the first stack 110A and the second stack 120A, or the benefits of stack efficiency improved by implementing inductors using a layout space between the first stack 110A and the second stack 120A without increasing a layout space are the same as those described in FIGS. 1, 3A, and 3B, and redundant descriptions will be omitted.

The output matching unit 170 may adjust impedance viewed from the side of a load at the output terminals of the third and fourth amplifier elements 113A and 114A. In this case, the load may be an antenna, but example embodiments are not limited thereto.

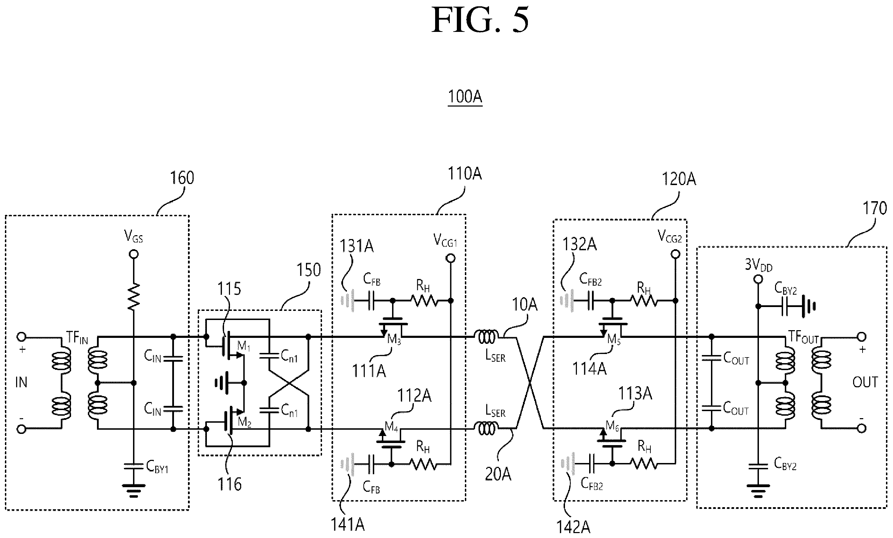

FIG. 5 is a circuit diagram illustrating an example of how to implement the 3-stack power amplifier of FIG. 4. Referring to FIG. 5, the 3-stack power amplifier 100A may include a first stack 110A, a second stack 120A, a third stack 150, an input matching unit 160, and an output matching unit 170.

The input matching unit 160 may receive a differential input signal IN, and may then transmit the received differential input signal IN to the third stack 150. Also, the input matching unit 160 may perform impedance matching with an external circuit providing the differential input signal IN. To this end, the input matching unit 160 may include an input transformer TF_{IN} and an input capacitor C_{IN}.

The third stack 150 may firstly amplify a differential input signal transmitted from the input matching unit 160. To this end, the third stack 150 may include a fifth amplifier element 115 (hereinafter referred to as "M1") and a sixth amplifier element (hereinafter referred to as "M2").

According to an example embodiment, M1 and M2 may have a common source structure. Therefore, a source terminal of M1 and a source terminal of M2 may each be connected to a ground.

A gate terminal of M1 may receive a first input signal, and a drain terminal of M1 may be connected to a source terminal of a first amplifier element 111A (hereinafter referred to as "M3") of the first stack 110A. A gate terminal of M2 may receive a second input signal, and a drain terminal of M2 may be connected to a source terminal of a second amplifier element 112A (hereinafter referred to as "M4") of the first stack 110A.

The third stack 150 may include two neutralization capacitors Cₙ₁. The neutralization capacitors Cₙ₁ may serve to cancel out parasitic capacitor components of M1 and M2. To this end, one of the neutralization capacitors Cₙ₁ may have one end connected to a gate terminal of M1 and the other end connected to a drain terminal of M2 and a source terminal of M4. The remaining one of the neutralization capacitors Cₙ₁ may have one end connected to a gate terminal of M2 and the other end connected to a drain terminal of M1 and a source terminal of M3.

The first stack 110A may secondly amplify the signal, firstly amplified in the third stack 110A. To this end, the first stack 110A may include M3 and M4. According to an example embodiment, M3 and M4 may have a common gate structure. Therefore, a gate terminal of M3 may be connected to a ground 131A of M3 through a feedback capacitor C_{FB}, and a gate terminal of M4 may be connected to a ground 141A of M4 through a feedback capacitor C_{FB}. The feedback capacitors C_{FB} may serve to respectively short-circuit AC signals, applied to the gate terminals of M3 and M4, to the grounds 131A and 141A and to respectively apply a driving voltage V_{CG1} to gate terminals of M3 and M4.

A source terminal of M3 may receive an output signal of M1, and a drain terminal of M3 may be connected to a source terminal of the third amplifier element 113A (hereinafter referred to as "M6") of the second stack 120A. A source terminal of M4 may receive an output signal of M2, and a drain terminal of M4 may be connected to a source terminal of the fourth amplifier element 114A (hereinafter referred to as "M5") of the second stack 120A. In this case, a drain terminal of M3 and a source terminal of M6 may be connected to each other through a first interconnection 10A, and a drain terminal of M4 and a source terminal of M5 may be connected to each other through a second interconnection 20A intersecting the first interconnection 10A.

The second stack 120A may thirdly amplify the signal, secondly amplified in the first stack 100A. To this end, the second stack 120A may include M5 and M6. According to an example embodiment, M5 and M6 may have a common gate structure. Therefore, a gate terminal of M5 may be connected to a ground 132A of M5 through a feedback capacitor C_{FB2}. A gate terminal of M6 may be connected to a ground 142A of M6 through a feedback capacitor C_{FB2}. The feedback capacitors C_{FB2} may serve to respectively short-circuit AC signals, applied to the gate terminals of M5 and M6, to the grounds 132A and 142A and to respectively apply a driving voltage V_{CG2} to the gate terminals of M5 and M6.

A parasitic capacitance component is present in each of M3, M4, M5, and M6, so that an output signal may be coupled to a ground of a corresponding amplifier element. For example, an output signal of M3 may be coupled to the gate terminal of M3 through a parasitic capacitance component present between the drain terminal and the gate terminal of M3, and may then be coupled to the ground 131A of M3 through the feedback capacitor C_{FB}. Similarly, output signals of M4, M5, and M6 may be coupled to the grounds 141A, 132A, and 142A of M4, M5, and M6, respectively.

In this case, the first interconnection 10A and the second interconnection 20A cross-couple the drain terminals of M3 and M4 and the source terminals of M5 and M6, so that a phase of the output signal of M3 and a phase of the output signal of M5 may be opposite to each other. According to an example embodiment, the ground 131A of M3 and the ground 132A of M5 are connected to each other, so that an output signal of M3 coupled to the ground 131A of M3 and an output signal of M5 coupled to the ground 132A of M5 may cancel each other out.

In addition, the first interconnection 10A and the second interconnection 20A cross-couple the drain terminals of M3 and M4 and the source terminals of M5 and M6, so that a phase of the output signal of M4 and a phase of the output signal of M6 may also be opposite to each other. According to an example embodiment, the ground 141A of M4 and the ground 142A of M6 are connected to each other, so that an output signal of M4 coupled to the ground 141A of M4 and an output signal of M6 coupled to the ground 142A of M6 may cancel each other out.

Accordingly, a virtual ground may be formed between the first stack 110A and the second stack 120A, and stability of the 3-stack power amplifier 100A may be improved.

In a multi-stack power amplifier having a general differential structure, a feedback capacitor connected to a gate terminal of an amplifier element having a common gate structure may affect both stability and gain of a circuit. For example, the larger a capacitance value of the feedback capacitor, the greater the gain, but more unnecessary signals may be coupled, so that the stability of the circuit may be degraded. Accordingly, in the multi-stack power amplifier having the general differential structure, optimization of the capacitance value of the feedback capacitor may be limited to secure the stability of the circuit. However, in the case of the above-described embodiments, output signals of amplifier elements may cancel each other out due to opposite phases thereof even when they are coupled to a ground, so that capacitance values of the feedback capacitors C_{FB} and C_{FB2} may be optimized.

According to an example embodiment, series inductors L_{SER} for compensating for phase misalignment of output signals may be implemented using the interconnections 10A and 20A intersecting each other in a layout space between the stacks 110A and 120A. As a result, the stack efficiency of the 3-stack power amplifier 100A may be improved without increasing a layout space required to add an inductor.

The output matching unit 170 may transfer output signals, output from an output terminal of the second stack 120A (for example, the drain terminal of M5 and the drain terminal of M6), to an external load. Also, the output matching unit 170 may adjust impedance viewed from the side of a load at an output terminal of the second stack 120A. To this end, the output matching unit 170 may include output capacitors C_{OUT} and an output transformer TF_{OUT}.

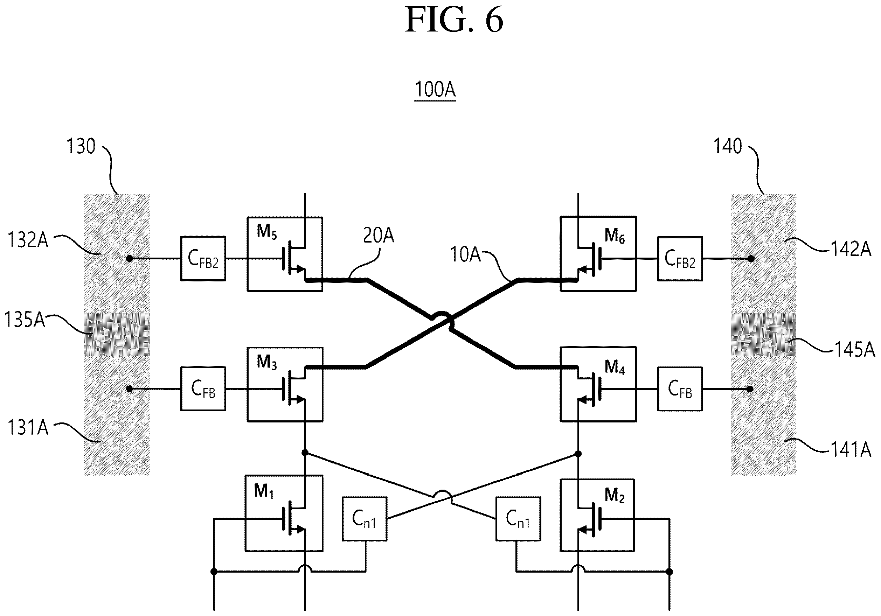

FIG. 6 is a diagram illustrating an example of a layout of the 3-stack power amplifier of FIG. 5. Referring to FIG. 6, M1 to M6 may be disposed on a substrate including a plurality of layers, as illustrated.

A gate terminal of M3 may be connected to a ground 131A of M3 through a feedback capacitor C_{FB}. A gate terminal of M4 may be connected to a ground 141A of M4 through a feedback capacitor C_{FB}. A gate terminal of M5 may be connected to a ground 132A of M5 through a feedback capacitor C_{FB2}. A gate terminal of M6 may be connected to a ground 142A of M6 through a feedback capacitor C_{FB2}.

In this case, the ground 131A of M3 and the ground 132A of M5 may be connected to each other through a region 135A through which the two grounds 131A and 132A are connected to each other. The ground 131A of M3, the ground 132A of M5, and the region 135A may correspond to the above-described first ground region 130. The ground 141A of M4, the ground 142A of M6, and the region 145A may correspond to the above-described ground region 140.

A drain terminal of M3 and a source terminal of M6 may be connected through a first interconnection 10A, and a drain terminal of M4 and a source terminal of M5 may be connected through a second interconnection 20 intersecting the first interconnection 10A. In this case, the first interconnection 10A and the second interconnection 20A may cross each other through different layers, among the plurality of layers.

Since the first wire 10A and the second wire 20A intersect each other, a phase of an output signal of M3 and a phase of an output signal of M5 may be opposite to each other. Accordingly, the output signal of M3 coupled to the ground 131A of M3 and the output signal of M5 coupled to the ground 132A of M5 may cancel each other out in a region 135A of the first ground 130.

In addition, since the first interconnection 10A and the second interconnection 20 intersect each other, a phase of an output signal of M4 and a phase of an output signal of M6 may be opposite to each other. Accordingly, the output signal of M4 coupled to the ground 141A of M4 and the output signal of M6 coupled to the ground 142A of M6 may cancel each other out in a region 145A of the second ground 140.

The first interconnection 10A and the second interconnection 20A may be implemented in layout spaces between M3, M4, M5, and M6. According to an example embodiment, the first interconnection 10A may have an inductance value causing the output signal of M3 and the output signal of M6 to be in phase. Additionally, the second interconnection 20A may have an inductance value causing the output signal of M4 and the output signal of M5 to be in phase.

According to an example embodiment, in the layout, a distance between M3 and M6 may be longer than a distance between M3 and M5 and a distance between M4 and M5 may be longer than a distance between M4 and M6, as illustrated in the drawing. Connecting M3 to M6 and M4 to M5, as in the first and second interconnections 10A and 20A, may allow for a relatively large inductance value to be implemented in the same area, compared with connecting M3 to M5 and M4 to M6.

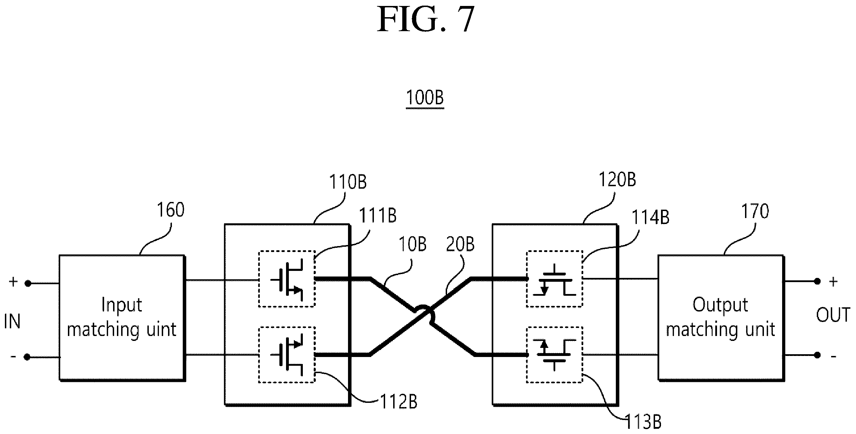

FIG. 7 is a block diagram of a 2-stack amplifier according to an example embodiment. Referring to FIG. 7, a 2-stack power amplifier 100B may include a first stack 110B, a second stack 120B, an input matching unit 160, and an output matching unit 170. The 2-stack power amplifier 100B may have a differential structure in which a differential input signal IN is amplified to output a differential output signal OUT. The input matching unit 160 and the output matching unit 170 are the same as described above with reference to FIGS. 4 and 5, and redundant descriptions will be omitted.

The first stack 110B may include a first amplifier element 111B and a second amplifier element 112B. The first amplifier element 111B may amplify a first input signal (for example, a signal input to a positive terminal) of a differential input signal IN, and may output the amplified signal to the third amplifier element 113B of the second stack 120B. The second amplifier element 112B may amplify a second input signal (for example, a signal input to a negative terminal) of the differential input signals IN, and may output the amplified signal to the fourth amplifier element 114B of the second stack 120B.

The second stack 120B may include a third amplifier element 113B and a fourth amplifier element 114B. The third amplifier element 113B may be connected to an output terminal of the first amplifier element 111B through a first interconnection 10B to amplify an output signal of the first amplifier element 111B. The fourth amplifier element 114B may be connected to an output terminal of the second amplifier element 112B through the second interconnection 20B, intersecting the first interconnection 10B, to amplify an output signal of the second amplifier element 112B.

The benefits of circuit stability improved by forming a virtual ground between the first stack 110A and the second stack 120A, or the benefits of stack efficiency improved by implementing inductors using a layout space between the first stack 110A and the second stack 120A without increasing a layout space are the same as those described in FIGS. 1, 3A, and 3B, so redundant descriptions will be omitted.

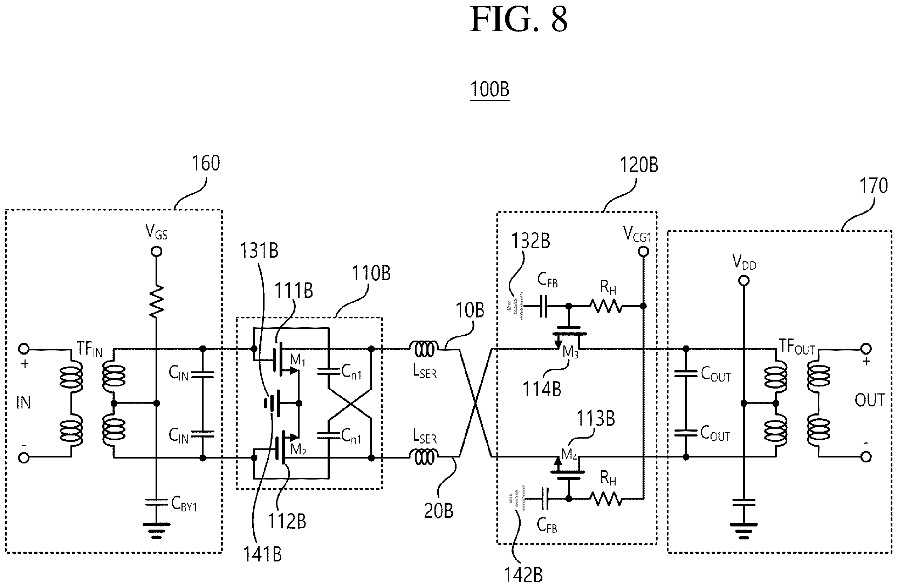

FIG. 8 is a circuit diagram illustrating an example of how to implement the two-stack amplifier of FIG. 7. Referring to FIG. 8, the 2-stack power amplifier 100B may include a first stack 110B, a second stack 120B, an input matching unit 160, and an output matching unit 170.

The input matching unit 160 may receive a differential input signal IN, and may then transmit the received signal to the first stack 110B. Also, the input matching unit 160B may perform impedance matching with an external circuit providing the differential input signal IN. To this end, the input matching unit 160 may include an input transformer TF_{IN} and input capacitors C_{IN}.

The first stack 110B may firstly amplify the differential input signal transmitted from the input matching unit 160. To this end, the first stack 110B may include a first amplifier element 111B (hereinafter referred to as "M1") and a second amplifier element 112B (hereinafter referred to as "M2").

According to an example embodiment, M1 and M2 may have a common source structure. Therefore, a source terminal of M1 and a source terminal of M2 may be connected to grounds 131B and 141B, respectively. The reference numeral 131B represents a region of a ground to which the source terminal of M1 is connected, and the reference numeral 141B represents a region of a ground to which the source terminal of M2 is connected.

A gate terminal of M1 may receive a first input signal, and a drain terminal of M1 may be connected to a source terminal of the third amplifier element 113B (hereinafter referred to as "M4") of the second stack 120B. A gate terminal of M2 may receive a second input signal, and a drain terminal of M2 may be connected to a source terminal of the fourth amplifier element 114 (hereinafter referred to as "M3") of the second stack 120B. The drain terminal of M1 and the source terminal of M4 may be connected through a first interconnection 10B, and the drain terminal of M2 and the source terminal of M3 may be connected through a second interconnection 20B intersecting the first interconnection 10B.

The first stack 110B may include two neutralization capacitors Cₙ₁. The neutralization capacitors Cₙ₁ may serve to cancel out parasitic capacitor components of M1 and M2. To this end, one of the neutralization capacitors Cₙ₁ may have one end, connected to the gate terminal of M1, and the other end commonly connected to the drain terminal of M2 and the source terminal of M3. Additionally, the remaining neutralization capacitor Cₙ₁ may have one end, connected to the gate terminal of M2, and the other end commonly connected to the drain terminal of M1 and the source terminal of M4.

The second stack 120B may secondly amplify the signal firstly amplified in the first stack 110B. To this end, the second stack 120B may include M3 and M4. According to an example embodiment, M3 and M4 may have a common gate structure. Therefore, a gate terminal of M3 may be connected to a ground 132B of M3 through a feedback capacitor C_{FB}. A gate terminal of M4 may be connected to a ground 142B of M4 through a feedback capacitor C_{FB}. The feedback capacitors C_{FB} may serve to respectively short-circuit AC signals, applied to the gate terminals of M3 and M4, to the grounds 132B and 142B and to respectively apply a driving voltage V_{CG1} to the gate terminals of M3 and M4.

The source terminal of M3 may receive an output signal of M2 through the second interconnection 20B, and the drain terminal of M3 may be connected to the output matching unit 170. The source terminal of M4 may receive an output signal of M1 through the first wire 10B, and the drain terminal of M4 may be connected to the output matching unit 170.

A parasitic capacitance component is present in each of M3, M4, M5, and M6, so that an output signal may be coupled to a ground of a corresponding amplifier element. For example, an output signal of M1 may be coupled to the ground 131B of M1 through a parasitic capacitance component present between the drain terminal and the source terminal of M1. Similarly, an output signal of M2 may be coupled to the ground 141B of M2. In addition, an output signal of M3 may be coupled to the gate terminal of M3 through a parasitic capacitance component present between the drain terminal and the gate terminal of M3, and may then be coupled to the ground 132B of M3 through the feedback capacitor C_{FB}. Similarly, an output signal of M4 may be coupled to the ground 142B of M4.

In this case, the first interconnection 10B and the second interconnection 20B cross-couples the drain terminals of M1 and M2 and the source terminals of M3 and M4, so that a phase of the output signal of M1 and a phase of the output signal of M3 may be opposite to each other. According to an example embodiment, the ground 131B of M1 and the ground 132B of M3 are connected to each other, so that the output signal of M1 coupled to the ground 131B of M1 and the output signal of M3 coupled to the ground 132B of M3 may cancel each other out.

In addition, the first interconnection 10B and the second interconnection 20B cross-couples the drain terminals of M1 and M2 and the source terminals of M3 and M4, so that a phase of the output signal of M2 and a phase of the output signal of M4 may be opposites to each other. According to an example embodiment, the ground 141B of M2 and the ground 142B of M4 are connected to each other, so that the output signal of M2 coupled to the ground 141B of M2 and the output signal of M4 coupled to the ground 142B of M4 may cancel each other out.

Accordingly, a virtual ground may be formed between the first stack 110B and the second stack 120B, and the stability of the 2-stack power amplifier 100B may be improved. In addition, a capacitance value of the feedback capacitors C_{FB} may be optimized in consideration of only a gain.

According to an example embodiment, series inductors L_{SER} for compensating for phase misalignment of output signals may be implemented using interconnections 10B and 20B intersecting each other in a layout space between the stacks 110B and 120B. Accordingly, stack efficiency of the two-stack power amplifier 100B may be improved without increasing a layout space for adding inductors.

The output matching unit 170 may transmit output signals, output from the output terminal of the second stack 120B (for example, the drain terminal of M3 and the drain terminal of M4), to an external load. Also, the output matching unit 170 may adjust impedance viewed at the side of a load from the output terminal of the second stack 120B. To this end, the output matching unit 170 may include output capacitors C_{OUT} and an output transformer TF_{OUT}.

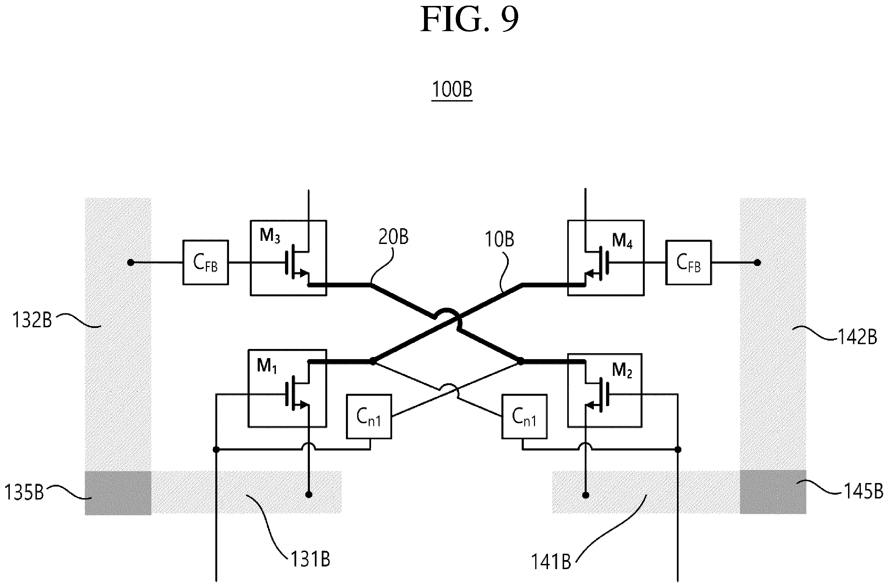

FIG. 9 is a diagram illustrating an example of the layout of the two-stack power amplifier of FIG. 8. Referring to FIG. 9, M1 to M4 may be disposed on a substrate including a plurality of layers, as illustrated.

In this case, a source terminal of M1 may be connected to a ground 131B of M1. A source terminal of M2 may be connected to a ground 141B of M2. A gate terminal of M3 may be connected to a ground 132B of M3 through a feedback capacitor C_{FB}. A gate terminal of M4 may be connected to a ground 142B of M4 through a feedback capacitor C_{FB}.

In this case, the ground 131B of M1 and the ground 132B of M3 may be connected to each other through a region 135B through which the two grounds 131B and 132B are connected to each other. In addition, the ground 141B of M2 and the ground 142B of M4 may be connected to each other through a region 145B in which the two grounds 141B and 142B are connected to each other. The ground 131B of M1, the ground 132B of M3, and the region 135B may correspond to the above-described first ground region 130. In addition, the ground 141B of M2, the ground 142B of M4, and the region 145B may correspond to the above-described second ground region 140.

A drain terminal of M1 and a source terminal of M4 may be connected to each other through the first interconnection 10B, and a drain terminal of M2 and a source terminal of M3 are connected to each other through a second interconnection 20B intersecting first interconnection 10B. In this case, the first interconnection 10B and the second interconnection 20B may intersect each other through different layers, among the plurality of layers.

Since the first wire 10B and the second wire 20B intersect each other, a phase of an output signal of M1 and a phase of an output signal of M3 may be opposite to each other. Accordingly, the output signal of M1 coupled to the ground 131B of M1 and the output signal of M3 coupled to the ground 132B of M3 may cancel each other in a region of the first ground 130.

In addition, since the first interconnection 10B and the second interconnection 20B intersect each other, a phase of the output signal of M2 and a phase of the output signal of M4 may be opposite to each other. Accordingly, the output signal of M2 coupled to the ground 141B of M2 and the output signal of M4 coupled to the ground 142B of M4 may cancel each other in a region of the second ground 140.

The first interconnection 10B and the second interconnection 20B may be implemented in a layout space between M1, M2, M3, and M4. According to an example embodiment, the first interconnection 10B may have an inductance value causing the output signal of M1 and the output signal of M4 to be in phase. In addition, the second interconnection 20B may have an inductance value causing the output signal of M2 and the output signal of M3 to be in phase.

According to an example embodiment, in the layout, a distance between M1 and M4 may be longer than a distance between M1 and M3 and a distance between M2 and M3 may be longer than a distance between M2 and M4, as illustrated in the drawing.

Connecting M1 to M4 and M2 to M3, as in the first and second interconnections 10B and 20B, may allow for a relatively large inductance value to be implemented in the same area, compared with connecting M1 to M3 and M2 to M4.

Examples of the 3-stack power amplifier 100A and the 2-stack power amplifier 100B have been described, but example embodiments are not limited thereto. For example, in the 3-stack power amplifier 100A of FIG. 4, not only the first stack 110A and the second stack 120A but also the third stack 150 and the first stack 110A may be cross-coupled to each other. In addition, example embodiments may be applied to a power amplifier having 4 or more stacks.

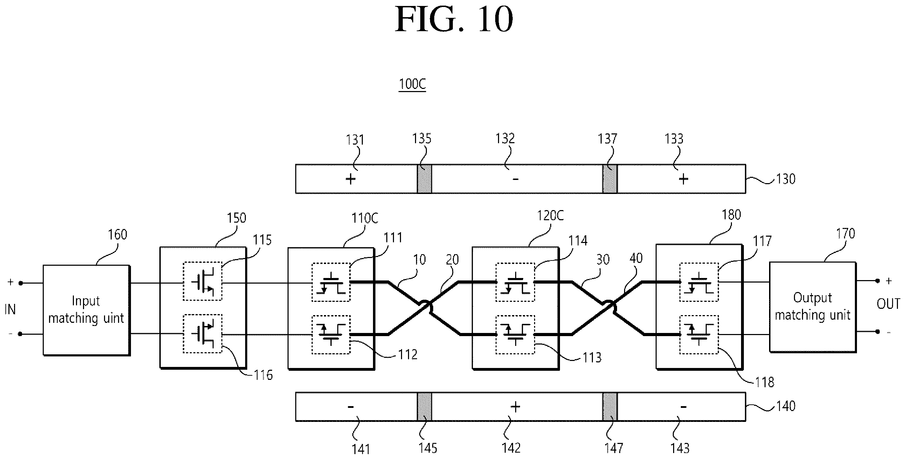

FIG. 10 is a block diagram of a 4-stack power amplifier according to an example embodiment. In description of FIG. 10, redundant descriptions overlapping those provided above will be omitted.

Referring to FIG. 10, a 4-stack power amplifier 100C may include a first stack 110C, a second stack 120C, a third stack 150, a fourth stack 180, an input matching unit 160, and an output matching unit 170. Compared to the 3-stack power amplifier 100A of FIG. 4, the 4-stack power amplifier 100C may further include the fourth stack 180.

The fourth stack 180 may include a seventh amplifier element 117 and an eighth amplifier element 118. The eighth amplifier element 118 may be connected to an output terminal of the fourth amplifier element 114 through a third interconnection 30 to amplify an output signal of a fourth amplifier element 114. The seventh amplifier element 117 may be connected to an output terminal of a third amplifier element 113 through a fourth interconnection 40, intersecting the third interconnection 30, to amplify an output signal of the third amplifier element 113.

The 4-stack power amplifier 100C may include a first ground 130 to which grounds 131, 132, and 133 of the first amplifier 111, the fourth amplifier 114, and the seventh amplifier 117 are connected. Also, the 4-stack power amplifier 100C may include a second ground 140 to which grounds 141, 142, and 143 of the second amplifier element 112, the third amplifier element 113, and the eighth element 118 are connected.

In this case, the first interconnection 10 and the second interconnection 20 between the first stack 110C and the second stack 120C intersect each other and the third interconnection 30 and the fourth interconnection 40 between the second stack 120C and the fourth stack 180 intersect each other. Therefore, output signals having opposite phases may be coupled to the first and second grounds 130 and 140, as illustrated by "+" and "-" in the drawing.

Accordingly, an output signal of the first amplifier element 111, an output signal of the fourth amplifier element 114, and an output signal of the seventh amplifier element 117, coupled to the first ground 130, may cancel each other out. In addition, a virtual ground may be formed in a region 135 through which the grounds 131 and 132 are connected to each other, and a virtual ground may be formed in a region 137 through which the grounds 132 and 133 are connected to each other. Similarly, an output signal of the second amplifier element 112, an output signal of the third amplifier element 113, and an output signal of the eighth amplifier element 118, coupled to the second ground 140, may cancel each other out. In addition, a virtual ground may be formed in a region 145 through which the grounds 141 and 142 are connected to each other, and a virtual ground may be formed in a region 147 through which the grounds 142 and 143 are connected to each other. As a result, stability of the 4-stack power amplifier 100C may be improved.

Referring to FIG. 10, the third interconnection 30 and the fourth interconnection 40 may cross-couple the second stack 120C and the fourth stack 180. Accordingly, series inductors may be implemented using a layout space between the second stack 120C and the fourth stack 180 in which the third and fourth wires 30 and 40 intersect each other. As a result, phase misalignment between the output signal of the third amplifier element 113 and the output signal of the seventh amplifier element 117 and phase misalignment between the output signal of the fourth amplifier element 114 and the output signal of the eighth amplifier element 118 may be compensated for. In this case, the manner of implementing the inductor using the third interconnection 30 and the fourth interconnection 40 is similar to the above-described in connection with the first interconnection 10 and the second interconnection 20, and redundant descriptions will be omitted.

An example, in which the amplifier elements of the multi-stack power amplifier 100 are field effect transistors (FET), has been described, but example embodiments are not limited thereto. For example, other elements such as a bipolar junction transistor (BJT) may be implemented as amplifier elements of the multi-stack power amplifier 100.

In addition, the above-described multi-stack power amplifier 100 may be a power amplifier for amplifying signals in a high-frequency band such as mmWave. However, example embodiments are not limited thereto. Various embodiments may be applied to differential amplifiers having a stack structure, regardless of a frequency.

As set forth above, according to example embodiments, a multi-stack power amplifier having a differential structure, which may reduce circuit instability caused by feedback of an unwanted signal and improve stack efficiency without additional or increased layout space, may be provided.

Various references may have been made herein to one signal cancelling another signal. Such references should not be interpreted as requiring complete and total cancellation of both signals to the point of undetectability. Instead, less-than perfect cancellation is encompassed by use of the term. For example, two signals may be said to cancel each other if the amplitude of a resulting signal is less than about 50% of at least one of the signals' amplitudes prior to cancellation. Thus, for example, a signal of .04 volts and a signal of-.05 volts may be said to cancel each other, even if a signal having an amplitude of -.01 volts remains.

As may also be used herein, the term(s) "configured to", "operably coupled to", "coupled to", and/or "coupling" includes direct coupling between items and/or indirect coupling between items via an intervening item (e.g., an item includes, but is not limited to, a component, an element, a circuit, and/or a module) where, for an example of indirect coupling, the intervening item does not modify the information of a signal but may adjust its current level, voltage level, and/or power level. As may further be used herein, inferred coupling (i.e., where one element is coupled to another element by inference) includes direct and indirect coupling between two items in the same manner as "coupled to".

While example embodiments have been shown and described above, it will be apparent to those skilled in the art that modifications and variations could be made without departing from the scope of the present inventive concept as defined by the appended claims.

## Claims

1. A multi-stack power amplifier having a differential structure, the multi-stack power amplifier comprising:
a first stack comprising a first amplifier element, configured to amplify a first signal having a first phase, and a second amplifier element configured to amplify a second signal having a second phase opposite to the first phase; and
a second stack comprising a third amplifier element, connected to an output terminal of the first amplifier element through a first interconnection, and a fourth amplifier element connected to an output terminal of the second amplifier element through a second interconnection intersecting the first interconnection.

2. The multi-stack power amplifier of claim 1, wherein
a phase of a first coupling signal, coupled to a first ground through the first amplifier element, and a phase of a second coupling signal, coupled to the first ground through the fourth amplifier element, are opposite to each other, and
a phase of a third coupling signal, coupled to a second ground through the second amplifier element, and a phase of a fourth coupling signal, coupled to the second ground through the third amplifier element, are opposite to each other.

3. The multi-stack power amplifier of claim 2, wherein
the first ground comprises a ground of the first amplifier element and a ground of the fourth amplifier element, connected to each other, and
the second ground comprises a ground of the second amplifier element and a ground of the third amplifier element, connected to each other.

4. The multi-stack power amplifier of claim 3, wherein
a first virtual ground, in which the first coupling signal and the second coupling signal cancel each other out, is formed in a region through which a ground of the first amplifier element and a ground of the fourth amplifier element are connected to each other, and
a second virtual ground, in which the third coupling signal and the fourth coupling signal cancel each other out, is formed in a region through which a ground of the second amplifier element and a ground of the third amplifier element are connected to each other.

5. The multi-stack power amplifier of any one of claims 1 to 4, wherein
each of the first and second interconnections is disposed within a layout space comprising the first to fourth amplifier elements.

6. The multi-stack power amplifier of any one of claims 1 to 5, wherein
the first interconnection includes an inductance configured to compensate for a phase difference between an output signal of the first amplifier element and an output signal of the third amplifier element, and
the second interconnection includes an inductance configured to compensate for a phase difference between an output signal of the second amplifier element and an output signal of the fourth amplifier element.

7. The multi-stack power amplifier of claim 6, wherein
the inductance of the first interconnection has a value causing the output signal of the first amplifier element and the output signal of the third amplifier element to be in phase, and
the inductance of the second interconnection has a value causing the output signal of the second amplifier element and the output signal of the fourth amplifier element to be in phase.

8. The multi-stack power amplifier of any one of claims 1 to 7, wherein
the first to fourth amplifier elements are disposed on a substrate comprising a plurality of layers, and
the first interconnection and the second interconnection intersect each other through different layers of the plurality of layers.

9. The multi-stack power amplifier of any one of claims 1 to 8, comprising:
a third stack comprising a fifth amplifier element configured to amplify a first input signal of a differential input signal and generate the first signal, and a sixth amplifier element configured to amplify a second input signal of the differential input signal and generate the second signal,
wherein
each of the fifth and sixth amplifier elements is a common source amplifier, and
each of the first to fourth amplifier elements is a common gate amplifier.

10. The multi-stack power amplifier of claim 9, comprising:
a first feedback capacitor connected between a ground of the first amplifier element and a gate terminal of the first amplifier element;
a second feedback capacitor connected between a ground of the second amplifier element and a gate terminal of the second amplifier element;
a third feedback capacitor connected between a ground of the third amplifier element and a gate terminal of the third amplifier element; and
a fourth feedback capacitor connected between a ground of the fourth amplifier element and a gate terminal of the fourth amplifier element.

11. The multi-stack power amplifier of claim 10 when dependent on at least claim 2, wherein
the first coupling signal comprises an output signal of the first amplifier element, coupled to the ground of the first amplifier element through a parasitic capacitance component of the first amplifier element and the first feedback capacitor,
the second coupling signal comprises an output signal of the fourth amplifier element, coupled to the ground of the fourth amplifier element through a parasitic capacitance component of the fourth amplifier element and the fourth feedback capacitor,
the third coupling signal comprises an output signal of the second amplifier element, coupled to the ground of the second amplifier element through a parasitic capacitance component of the second amplifier element and the second feedback capacitor, and
the fourth coupling signal comprises an output signal of the third amplifier element, coupled to the ground of the third amplifier element through a parasitic capacitance component of the third amplifier element and the third feedback capacitor.

12. The multi-stack power amplifier of any one of claims 1 to 11, wherein
the first signal is a first input signal of a differential input signal,
the second signal is a second input signal of the differential input signal,
each of the first and second amplifier elements is a common source amplifier, and
each of the third and fourth amplifier elements is a common gate amplifier.

13. The multi-stack power amplifier of claim 12, wherein
a source terminal of the first amplifier element and a source terminal of the second amplifier element are connected to a ground of the first amplifier element and a ground of the second amplifier element, respectively, and
the multi-stack power amplifier comprising:
a first feedback capacitor connected between a ground of the third amplifier element and a gate terminal of the third amplifier element; and
a second feedback capacitor connected between a ground of the fourth amplifier element and a gate terminal of the fourth amplifier element.

14. The multi-stack power amplifier of claim 13 when dependent on at least claim 2, wherein
the first coupling signal comprises an output signal of the first amplifier element, coupled to the ground of the first amplifier element through a parasitic capacitance component of the first amplifier element,
the second coupling signal comprises an output signal of the fourth amplifier element, coupled to the ground of the fourth amplifier element through a parasitic capacitance component of the fourth amplifier element and the second feedback capacitor,
the third coupling signal comprises an output signal of the second amplifier element, coupled to the ground of the second amplifier element through a parasitic capacitance component of the second amplifier element, and
the fourth coupling signal comprises an output signal of the third amplifier element, coupled to the ground of the third amplifier element through a parasitic capacitance component of the third amplifier element and the first feedback capacitor.

15. The multi-stack power amplifier of any one previous claim comprising:
a first amplifier stage comprising the first stack, and a second amplifier stage comprising the second stack, wherein
an inductance of the first interconnection has a value causing an output signal of the first amplifier element and an output signal of the third amplifier element to be in phase, and
an inductance of the second interconnection has a value causing an output signal of the second amplifier element and an output signal of the fourth amplifier element to be in phase.
